# EUROPEAN PATENT SPECIFICATION

(11) **EP 4 590 093 B1**
(45) Date of publication and mention of the grant of the patent: **30.09.2026**
(21) Application number: 24867194.3
(22) Date of filing: 16.08.2024
(51) Int. Cl.: H10F 19/90, H10F 77/00, H10F 77/30, H10F 19/00, H10F 10/14, H10F 10/166, H10F 77/20

(54) **SOLAR CELL SHEET, CELL ASSEMBLY AND PHOTOVOLTAIC SYSTEM**
SOLARZELLENFOLIE, ZELLENANORDNUNG UND FOTOVOLTAISCHES SYSTEM
FEUILLE DE CELLULE SOLAIRE, ENSEMBLE CELLULE ET SYSTÈME PHOTOVOLTAÏQUE

(30) Priority: 22.09.2023 CN 202311238243; 17.04.2024 CN 202420798601 U; 17.04.2024 CN 202420802407 U
(43) Date of publication of application: 23.07.2025
(73) Proprietor: Zhuhai Fushan Aiko Solar Energy Technology Co., Ltd., Zhuhai, Guangdong 519000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: LIU, Ruimin, Zhuhai, Guangdong 519000 (CN); WANG, Yongqian, Zhuhai, Guangdong 519000 (CN); CHEN, Gang, Zhuhai, Guangdong 519000 (CN)
(74) Representative: EP&C
(86) International application number: PCT/CN2024/112781
(87) International publication number: WO 2025/060777

(56) References cited:
- CN-A- 108 987 503
- CN-A- 114 613 866
- CN-A- 114 613 866
- CN-A- 116 031 314
- CN-U- 216 311 796
- CN-U- 216 311 796
- CN-U- 221 176 233

## Description

### Cross-Reference to Related Application

The disclosure claims the priority and benefits to Chinese patent applications No.202311238243.4 filed with the China National Intellectual Property Administration on September 22, 2023, and No. 202420802407.5 and No. 202420798601.0 filed with the China National Intellectual Property Administration on April 17, 2024.

### Technical Field

The disclosure relates to the technical field of solar cells, and particularly relates to a solar cell, a cell component, and a photovoltaic system.

### Background

At present, all types of solar cells (such as Topcon solar cells, HJT solar cells, and back-contact solar cells) are provided with doped layers on which fingers and busbars are arranged. The fingers penetrate fingers of a passivation film layer, so as to make contact with the doped layers for current collection. The busbars are connected to the fingers, so as to collect currents of the fingers. For connecting two solar cells, the cells are required to be equipped with welding spots so as to be welded to a welding strip. The welding spots are generally set on the passivation film layer.

CN 216311796 U discloses a passivation contact back contact solar cell comprising a silicon substrate, the back surface of the silicon substrate is successively provided with a first tunneling passivation layer, a doped film layer and a back dielectric film layer covering the doped film layer; wherein the doped film layer comprises a first type doped film layer and a second type doped film layer, the first type doped film layer is arranged on the first tunneling passivation layer, a plurality of grooves arranged at intervals are formed in the surface of the first type doped film layer, the inner surfaces of the grooves are covered with second tunneling passivation layers, and the second type doped film layer is arranged on the second tunneling passivation layer. And one second type doped film layer is arranged in each groove. According to the solar cell provided by the utility model, direct contact between the metal electrode and the silicon substrate is avoided by arranging the tunneling passivation layer, and the second type doped film layer is arranged in the groove with the tunneling passivation layer on the surface of the first type doped film layer, so that electric leakage caused by contact between the doped film layers is avoided, and meanwhile, the coverage area of the doped film layers is also increased.

CN 114613866 A discloses a solar cell and a preparation method thereof. The solar cell comprises a silicon substrate, a front electrode and a back electrode, the front electrode and the back electrode are arranged on the two sides of the silicon substrate respectively, and a tunneling layer, a doped polycrystalline silicon layer and an antireflection layer are sequentially arranged on the front face of the silicon substrate in a stacked mode; the front electrode penetrates through the antireflection layer and is in contact with the doped polycrystalline silicon layer; an intrinsic amorphous silicon layer, a doped amorphous layer and a transparent conductive layer are sequentially stacked on the back surface of the silicon substrate, and the back electrode is arranged on the surface of one side, deviating from the silicon substrate, of the transparent conductive layer. According to the solar cell and the preparation method thereof, the passivation performance of the surface of the cell can be improved, parasitic absorption of incident light rays by a related film layer on the front side of the cell is reduced, the utilization rate of the incident light rays is increased, and the solar cell can be prepared by taking the intrinsic amorphous silicon layer and the doped amorphous layer as a back passivation structure. The defects possibly evolved in the high-temperature process are reduced, and the service life of the battery is prolonged.

CN 116031314 A discloses a photovoltaic cell and a photovoltaic module. The photovoltaic cell comprises a semiconductor substrate, a passivation layer arranged on the surface of the semiconductor substrate, and main grid lines and welding spots arranged on the passivation layer. The welding spots are used for being electrically connected with the welding strips, the welding spots are arranged on the sides, away from the passivation layer, of the main grid lines in the thickness direction of the photovoltaic cell, or the welding spots are arranged on the passivation layer, the main grid lines comprise connecting lines distributed at intervals in the first direction, and the adjacent connecting lines are electrically connected through the welding spots; in the thickness direction of the photovoltaic cell, the vertical distance between the highest point of the welding spot and the surface of the passivation layer is L1, the vertical distance between the main grid line and the surface of the passivation layer is L2, L1 is larger than or equal to L2, when the welding strip is placed on the welding spot, a gap exists between the welding strip and the main grid line, the deformation allowance of the welding strip is increased, and the welding quality of the photovoltaic cell is improved. The risks that the welding strip contracts to pull welding spots to deform and the semiconductor substrate is warped and deformed are reduced, and the risk that the photovoltaic cell is pulled by the welding strip to deform and damage when the temperature is reduced is reduced.

### Summary

The invention is set out in the appended claims.

Additional aspects and advantages of the disclosure will be set forth partially in the following description, and will become obvious in the following description, or can be learned by practice of the disclosure.

### Brief Description of the Drawings

Fig. 1 is a schematic module diagram of a photovoltaic system according to an example of the disclosure;
Fig. 2 is a schematic module diagram of a cell component according to an example of the disclosure;
Fig. 3 is a schematic structural diagram of a solar cell according to an example of the disclosure;
Fig. 4 is another schematic structural diagram of a solar cell according to an example of the disclosure;
Fig. 5 is yet another schematic structural diagram of a solar cell according to an example of the disclosure;
Fig. 6 is still another schematic structural diagram of a solar cell according to an example of the disclosure;
Fig. 7 is a schematic diagram of a planer structure of a solar cell according to an example of the disclosure;
Fig. 8 is a schematic diagram of a section along line VI-VI of a back-contact cell in Fig. 7;
Fig. 9 is a schematic diagram of another section along line VI-VI of a back-contact cell in Fig. 7;
Fig. 10 is a schematic diagram of yet another section along line VI-VI of a back-contact cell in Fig. 7;
Fig. 11 is a schematic diagram of still another section along line VI-VI of a back-contact cell in Fig. 7;
Fig. 12 is a schematic diagram of another planer structure of a solar cell according to an example of the disclosure;
Fig. 13 is a schematic diagram of a section along line IX-IX of a back-contact cell in Fig. 12;
Fig. 14 is a schematic diagram of a section along line X-X of a back-contact cell in Fig. 12;
Fig. 15 is a schematic diagram of another section along line IX-IX of a back-contact cell in Fig. 12;
Fig. 16 is a schematic diagram of another section along line X-X of a back-contact cell in Fig. 12; and
Fig. 17 is a schematic diagram of yet another planer structure of a solar cell according to an example of the disclosure.

### Detailed Description of the Embodiments

For making objectives, technical solutions and advantages of the disclosure clearer, the disclosure will be further described in detail below in conjunction with the accompanying drawings and examples. The examples described with reference to the accompanying drawings are illustrative and only intended to explain the disclosure, instead of limiting the disclosure. In addition, it should be understood that specific examples described herein are merely used to explain the disclosure, and are not used to limit the disclosure.

In the description of the disclosure, it should be understood that orientations or positional relations indicated by the terms "length", "width", "upper", "lower", "top", "bottom", "transverse", "longitudinal", etc. are based on orientations or positional relations shown in the accompanying drawings, are merely for facilitating the description of the disclosure and simplifying the description, rather than indicating or implying that a device or element referred to must have a particular orientation or must be constructed and operated in a particular orientation, and therefore cannot be interpreted as limiting the disclosure.

In addition, the terms "first" and "second" are merely for descriptive purposes and are not to be construed as indicating or implying their relative importance or implicitly specifying the number of indicated technical features. Thus, features defined with "first" and "second" can explicitly or implicitly include at least one of the features. In the description of the disclosure, "a plurality of" indicates two or more, unless expressly specified otherwise.

In the description of the disclosure, it should be noted that, unless expressly specified and defined otherwise, the terms "mount", "connect", and "connected" are to be construed broadly. For instance, they can denote fixed connection, detachable connection or integral connection, denote mechanical connection, electric connection or mutual communication, denote direct connection or indirect connection by means of an intermediate medium, or denote communication between interiors of two elements or interaction between two elements. For those of ordinary skill in the art, specific meanings of the above terms in the disclosure can be understood according to specific circumstances.

In the disclosure, unless otherwise specified and limited, a case of a first feature "on" or "under" a second feature may include direct contact between the first and second features, or may include a case that the first and second features are not in direct contact with each other and are in contact with each other by means of another feature therebetween. Moreover, a case of the first feature "on", "above" and "on an upper portion of" the second feature includes a case that the first feature is directly above and obliquely above the second feature, or only indicates that a horizontal height of the first feature is greater than that of the second feature. A case of the first feature "under", "below" and "on a lower portion of" the second feature includes a case that the first feature is directly below and obliquely below the second feature, or only indicates that a horizontal height of the first feature is smaller than that of the second feature.

Many different examples or instances will be disclosed below so as to implement different structures of the disclosure. In order to simplify the disclosure, components and arrangements of specific instances will be described below. Clearly, the instances are only illustrative and are not intended to limit the disclosure. In addition, reference numerals and/or reference letters can be repeated in different instances of the disclosure for purposes of simplicity and clarity, and do not indicate relations between the various examples and/or arrangements discussed. In addition, the disclosure provides instances of various specific processes and materials. However, those of ordinary skill in the art can be aware of application of other processes and/or use scenes of other materials.

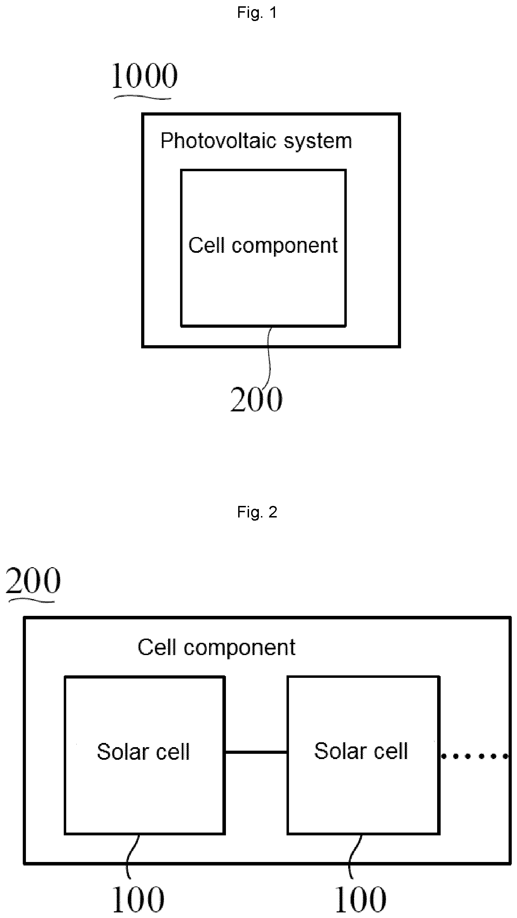

With reference to Figs. 1-2, a photovoltaic system 1000 of an example of the disclosure may include a cell component 200 of an example of the disclosure. The cell component 200 of the example of the disclosure may include several cell strings. Each of the cell strings may include several solar cells 100 of an example of the disclosure. In the disclosure, a plurality of solar cells 100 of the cell component 200 may be sequentially connected in series by means of a welding strip, so as to form a cell string. Each cell string of the cell component 200 may be connected in series, in parallel, or in a series-parallel connection manner, so as to output currents in a converged manner. For instance, all cell strings may be connected to each other by means of a bus bar.

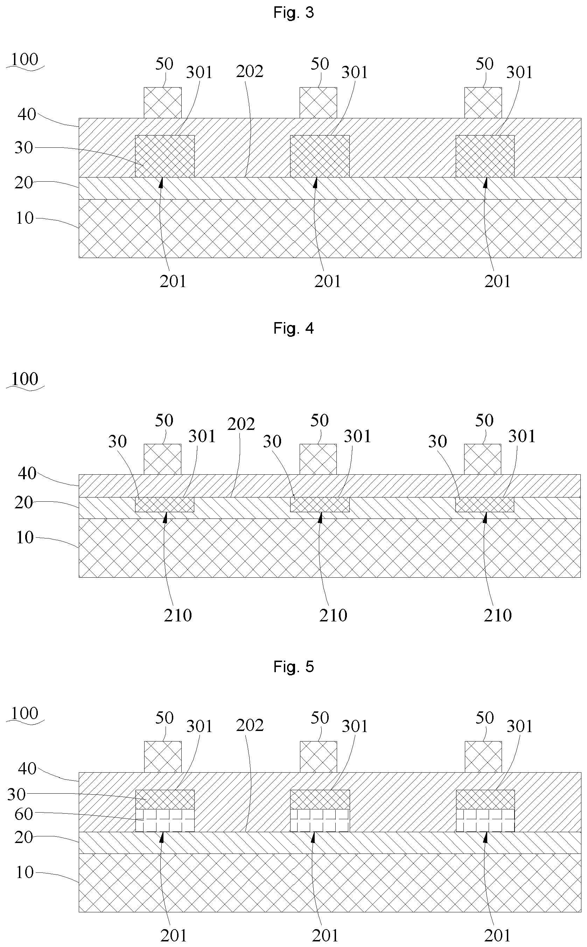

With reference to Figs. 3 and 4, the solar cell 100 of the example may include a silicon substrate 10, first doped layers 20, second doped layers 30, a first passivation film layer 40, and first welding spots 50.

The silicon substrate 10 has a first surface 11 and a second surface 12 opposite each other. The first doped layers 20 are arranged on the first surface 11. The first doped layers 20 each have several first preset zones 201. The several second doped layers 30 are arranged on the first preset zones 201, and the second doped layers 30 are arranged in a spaced manner.

The first passivation film layer 40 is arranged on the second doped layers 30 and the first doped layers 20. Specifically, the first passivation film layer 40 may cover the entire first doped layers 20 and second doped layers 30 (that is, the first passivation film layer 40 covers the second doped layers 30 and zones, not covered with the second doped layers 30, of the first doped layers 20).

The first welding spots 50 may be arranged on the first passivation film layer 40. Orthographic projections of the first welding spots 50 on the first doped layers 20 at least partially overlap orthographic projections of the second doped layers 30 on the first doped layers 20. That is, the first welding spots 50 are at least partially located above the second doped layers 30.

In other words, the first welding spots 50 at least partially overlap the second doped layers 30 in a thickness direction of the solar cell 100. It should be noted that, in the disclosure, the "orthographic projection" refers to an orthographic projection in the thickness direction of the solar cell 100, to which reference may be made for understanding if there is the same description below.

In the related art, a tensile force between a doped layer and a passivation film layer below a welding spot is weak, and the welding spot is prone to detachment due to an insufficient tensile force during welding.

In the solar cell of the example of the disclosure, the first preset zones 201 of the first doped layers 20 are provided with the second doped layers 30, and the second doped layers 30 are covered with the first passivation film layer 40. The orthographic projections of the first welding spots 50 on the first doped layers 20 at least partially overlap the orthographic projections of the second doped layers 30 on the first doped layers 20. In this way, the second doped layers 30 are arranged on the first doped layers 20, such that a bonding tensile force with the first passivation film layer 40 can be improved. The first welding spots 50 are arranged above the second doped layers 30 (that is, the orthographic projections of the first welding spots 50 on the first doped layers 20 at least partially overlap the orthographic projections of the second doped layers 30 on the first doped layers 20), such that a welding tensile force of the first welding spots 50 during welding can be effectively improved. Further, the first welding spots 50 can be effectively protected against detachment during welding, and welding reliability can be improved.

Specifically, in the disclosure, the solar cell 100 may be specifically a back-contact cell, a Topcon solar cell, an HJT solar cell, or another solar cell provided with the first doped layers 20 and provided with welding spots on the first doped layers 20, which is not specifically limited herein.

The polarity of the second doped layers 30 is opposite to that of the first doped layers 20. Roughness of surfaces 301 of the second doped layers 30 in contact with the first passivation film layer 40 is greater than that of surfaces 202 of the first doped layers 20 in contact with the first passivation film layer 40.

In this way, the roughness of the surfaces 301 of the second doped layers 30 in contact with the first passivation film layer 40 is greater than that of the surfaces 202 of the first doped layers 20 in contact with the first passivation film layer 40, such that a bonding tensile force between the first passivation film layer 40 and the second doped layers 30 can be much greater than that between the first passivation film layer 40 and the first doped layers 20. A welding tensile force of the first welding spots 50 during welding can be effectively improved, and further the first welding spots 50 can be effectively protected against detachment during welding.

Specifically, the first doped layers 20 and the second doped layers 30 may be P-type doped layers and N-type doped layers, respectively, as long as the polarity of the second doped layers is opposite to that of the first doped layers. For instance, In some embodiments, the first doped layers 20 may be P-type polysilicon layers, P-type amorphous silicon layers, or P-type microcrystalline silicon layers, which are not specifically limited herein. Similarly, the second doped layers 30 may be N-type polysilicon layers, N-type amorphous silicon layers, or N-type microcrystalline silicon layers, which are not specifically limited herein.

The polarity of the second doped layers 30 is opposite to that of the first doped layers 20, and the first doped layers 20 are P-type doped layers while the second doped layers 30 are N-type doped layers.

In some embodiments, a tunneling oxidation layer or an intrinsic amorphous silicon layer (not shown in the figure) may be arranged between the first doped layers 20 and the silicon substrate 10. Specifically, when the solar cell is the Topcon solar cell or the back-contact cell, a tunneling oxidation layer may be arranged between the first doped layers 20 and the silicon substrate 10. When the solar cell is the HJT solar cell, an intrinsic amorphous silicon layer may be arranged between the first doped layers 20 and the silicon substrate 10.

With reference to Fig. 3, In some embodiments, the first preset zones 201 are part of surfaces of the first doped layers 20 facing away from the silicon substrate 10, and the second doped layers 30 are arranged on the first preset zones 201 and all located above the first doped layers 20.

Specifically, as shown in Fig. 3, the first preset zones 201 are partial zones of the surfaces of the first doped layers 20 facing away from the silicon substrate 10, and are basically planar zones. In this case, the second doped layers 30 are directly arranged on the first doped layers 20 and are all located on the second doped layers 30.

With reference to Fig. 4, in some other examples, the first preset zones 201 may be first embedded recesses 210 formed on the first doped layers 20 in a sunken manner, and the second doped layers 30 are stacked in the first embedded recesses 210. The first welding spots 50 at least partially overlap the second doped layers 30 in a thickness direction of the solar cell 100.

It may be understood that, in the disclosure, the second doped layers 30 may be located in the first embedded recesses 210 as follows: all parts of the first doped layers 30 may be completely accommodated in the first embedded recesses 210, or the first doped layers 30 may partially extend out of the first embedded recesses 210 in the thickness direction, which are not specifically limited herein.

In some embodiments, a depth of the first embedded recesses 210 may be 5 nm-400 nm.

In this way, a poor tension enhancement effect caused when a thickness of the second doped layers 30 is too small due to a too small depth of the first embedded recesses 210 can be effectively avoided, or an increase in cost caused when a thickness of the second doped layers 30 is too large due to an excessive depth of the first embedded recesses 210 can be avoided.

Specifically, the depth of the first embedded recesses 210 may be 5 nm, 10 nm, 20 nm, 30 nm, 40 nm, 50 nm, 60 nm, 70 nm, 80 nm, 90 nm, 100 nm, 150 nm, 200 nm, 250 nm, 300 nm, 350 nm, 400 nm, or any numerical value between 5 nm and 400 nm, which is not specifically limited herein.

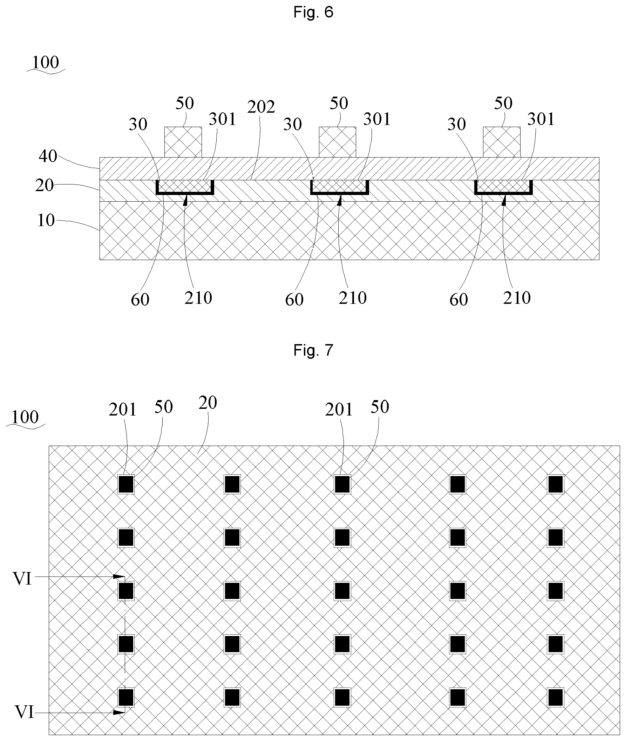

With reference to Figs. 5 and 6, In some embodiments, the solar cell 100 may further include first isolation layers 60. The first isolation layers 60 may be arranged between the first doped layers 20 and the second doped layers 30, so as to isolate the first doped layers 20 from the second doped layers 30.

In this way, the second doped layers 30 are isolated from the first doped layers 20 by means of the first isolation layers 60, such that the second doped layers can be prevented from making direct contact with the first doped layers. Meanwhile, a passivation effect of the first doped layers 20 can be ensured.

Specifically, in this case, as shown in Fig. 5, In some embodiments, the first isolation layers 60 may be directly arranged on surfaces of the first doped layers 20 and cover the first doped layers 20, and the second doped layers 30 may cover the first isolation layers 60. As shown in Fig. 6, In some embodiments, the first isolation layers 60 may be arranged on inner walls of the first embedded recesses 210. That is, the inner walls of the first embedded recesses 210 are provided with the first isolation layers 60, and the second doped layers 30 may cover the first isolation layers 60 in a stacked manner.

Clearly, it may be understood that, In some embodiments, the first isolation layers 60 do not need to be arranged to isolate the first doped layers 20 from the second doped layers 30, and only metal grid lines in contact with the first doped layers 20 in the solar cell 100 need to be arranged to make no contact with the second doped layers 30, which is not specifically limited herein.

In some embodiments, a thickness of the first isolation layers 60 may be greater than 2 nm. In this way, higher process difficulty due to a too small thickness of the first isolation layers 60 can be avoided.

In addition, In some embodiments, the first isolation layer 60 may include at least one of a silicon oxide film layer, a silicon nitride film layer, an aluminum oxide film layer, a silicon oxynitride film layer, a silicon carbide film layer, and an intrinsic amorphous silicon film layer.

Specifically, in the examples, the first isolation layers 60 may have a tunneling function or not, and may be an insulation layer or not, which is not specifically limited herein. A specific film layer may be selected according to different types of cells.

For instance, when the cell is a Topcon solar cell or a back-contact cell, the first isolation layer 60 may be at least one of a silicon oxide film layer, a silicon nitride film layer, an aluminum oxide film layer, a silicon oxynitride film layer, and a silicon carbide film layer. The first isolation layer 60 may have a tunneling function or not.

When the cell is an HJT solar cell, the first isolation layer 60 may be an intrinsic amorphous silicon layer. It may be understood that a specific selection of the first isolation layers 60 is only illustrated herein, and cannot be understood as a limitation to the disclosure.

As shown in Figs. 3-6, In some embodiments, an area of orthographic projections of the first preset zones 201 on the silicon substrate 10 is greater than or equal to that of orthographic projections of the first welding spots 50 on the silicon substrate 10, and the orthographic projections of the first welding spots 50 on the first doped layers 20 are completely located in the first preset zones 201. That is, the first welding spots 50 are completely located above the second doped layers 30 in the thickness direction of the solar cell 100. When the first preset zones 201 are the first embedded recesses 210, the orthographic projections of the first welding spots 50 on the first doped layers 20 are completely located in the first embedded recesses 210.

In this way, the first welding spots 50 are completely located in the first preset zones 201, and entire lower portions of the first welding spots 50 are all provided with the second doped layers, such that a welding tensile force at the first welding spots 50 can be enhanced to the greatest extent, and welding reliability can be ensured.

Specifically, in the examples, an area of the first preset zones 201 may preferably be just equal to the area of the orthographic projections of the first welding spots 50 or slightly greater than the area of the orthographic projections of the first welding spots 50.

Clearly, In some embodiments, the area of the orthographic projections of the first welding spots 50 on the first doped layers 20 may also be greater than that of the orthographic projections of the second doped layers 30 on the first doped layers 20 (that is, the area of the first preset zones 201). For instance, a single first welding spot 50 may correspond to a plurality of second doped layers 30. In this case, the first welding spot 50 may completely cover the second doped layers 30. In this case, a ratio of an overlapping area of the second doped layers 30 and the first welding spot 50 to a total area of the first welding spot 50 may be greater than 20%, such that a too small welding tensile force can be avoided.

The first welding spots 50 are bonded to upper portions of the first passivation film layer 40, or are partially embedded in the first passivation film layer 40, or
at least partially penetrate the first passivation film layer 40 so as to make contact with the second doped layers 30. When the first welding spots 50 are in contact with the second doped layers 30, the first isolation layers 60 may be arranged to isolate the first doped layers 20 from the second doped layers 30, which is not specifically limited herein.

In some embodiments, a thickness of the second doped layers 30 may be 5 nm-400 nm.

In this way, a poor tension enhancement effect due to a too small thickness of the second doped layers 30 can be effectively avoided, or higher process difficulty due to a too small thickness of the second doped layers 30 can be avoided. Meanwhile, an increase in cost due to an excessive thickness of the second doped layers 30 can be avoided.

Specifically, the thickness of the second doped layers 30 may be 5 nm, 10 nm, 20 nm, 30 nm, 40 nm, 50 nm, 60 nm, 70 nm, 80 nm, 90 nm, 100 nm, 150 nm, 200 nm, 250 nm, 300 nm, 350 nm, 400 nm, or any numerical value between 5 nm and 400 nm, which is not specifically limited herein.

In some embodiments, the first passivation film layer 40 may include at least one of a silicon nitride film layer, an aluminum oxide film layer, a silicon oxynitride film layer, an intrinsic amorphous silicon film layer, and a transparent conductive oxide (TCO) film layer.

Specifically, in the examples, a type of the first passivation film layer 40 may also be selected according to different types of cells. For instance, when the cell is a Topcon solar cell or a back-contact cell, the first passivation film layer 40 may be at least one of a silicon oxide film layer, a silicon nitride film layer, an aluminum oxide film layer, a silicon oxynitride film layer, and a silicon carbide film layer.

When the cell is an HJT solar cell, the first passivation film layer 40 may be a TCO film layer, which is not specifically limited herein. It may be understood that a specific selection of the first passivation film layer 40 is only illustrated herein, and cannot be understood as a limitation to the disclosure.

With reference to Figs. 7-13, In some embodiments, the solar cell 100 may further include third doped layers 70, a second passivation film layer 80, and several second welding spots 90. Polarity of the third doped layers 70 is opposite to that of the first doped layers 20.

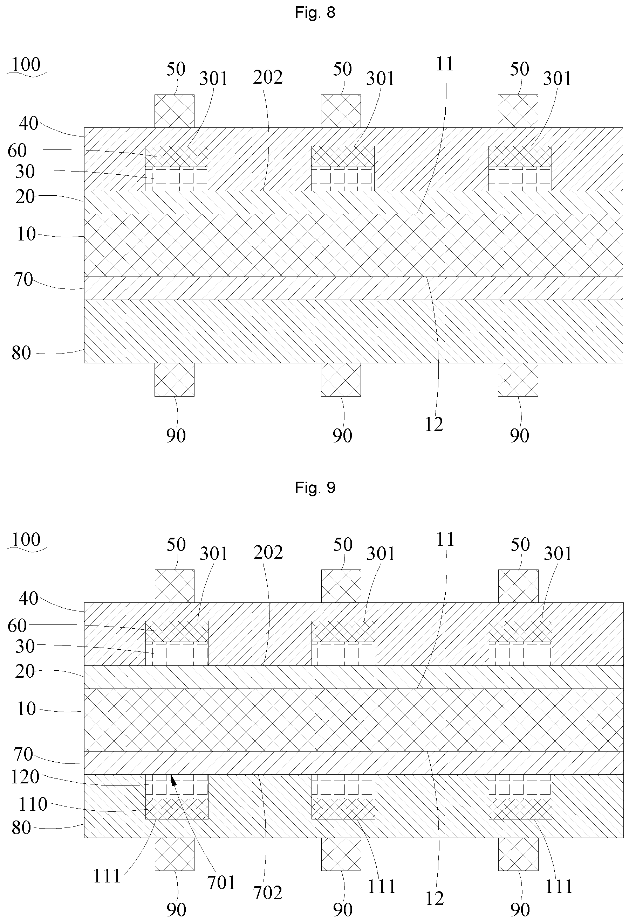

As shown in Figs. 8-11, In some embodiments, the first doped layers 20 may be arranged on the first surface 11, the third doped layers 70 may be arranged on the second surface 12, the second passivation film layer 80 may be arranged on the third doped layers 70, and the second welding spots 90 may be arranged on the second passivation film layer 80. In this case, the solar cell 100 is a double-sided solar cell, and for instance, a Topcon solar cell, an HJT solar cell, etc.

Similarly, in the disclosure, the second passivation film layer 80 may include at least one of a silicon nitride film layer, an aluminum oxide film layer, a silicon oxynitride film layer, an intrinsic amorphous silicon film layer, and a TCO film layer.

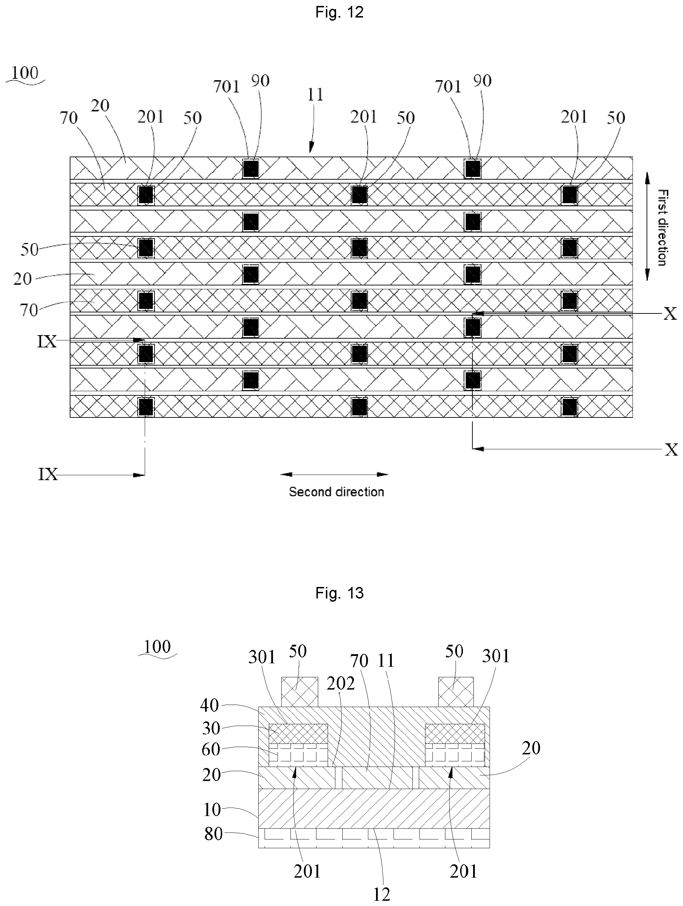

As shown in Figs. 12-16, In some embodiments, the first doped layers 20 and the third doped layers 70 may be all arranged on the first surface 11, the first passivation film layer 40 may be arranged on the first doped layers 20, the second doped layers 30, and the third doped layers 70, the second welding spots 90 may be arranged on the first passivation film layer 40, and the second passivation film layer 80 may be arranged on the second surface 12. In this case, if the solar cell 100 is a back-contact cell, the first surface 11 is a back surface of the cell, and the second surface 12 is a front surface of the cell.

In the example of the disclosure, in the solar cell 100, the second doped layers 30 may be obtained through partial removal of winding layers formed on the first doped layers 20 in a process of forming the above third doped layers 70, and the roughness of the second doped layers 30 may be controlled by controlling deposition temperature and time or through etching. Clearly, In some embodiments, the second doped layers 30 may also be directly obtained through deposition. Similarly, the roughness of the second doped layers 30 may also be controlled by controlling deposition temperature and time or through etching, which is not specifically limited herein.

It may be understood that when the solar cell 100 is a double-sided solar cell, the first passivation film layer 40 is provided with several first fingers (not shown in the figure), and the first fingers penetrate the first passivation film layer 40 so as to make contact with the first doped layer 20; and the second passivation film layer 80 is provided with several second fingers (not shown in the figure), and the second fingers penetrate the second passivation film layer 80 so as to make contact with the third doped layer 70. The double-sided solar cell is further provided with a first busbar (not shown in the figure) in cross-contact with the first fingers and a second busbar (not shown in the figure) in cross-contact with the second fingers. The first welding spots 50 may be arranged on the first busbar, which may be located on the first passivation film layer 40, or be partially embedded in the first passivation film layer 40, or penetrate the first passivation film layer 40 so as to make contact with the second doped layer 30 below the first passivation film layer 40. The first welding spots 50 are configured to be welded to a welding strip. Similarly, the second welding spots 90 may be arranged on the second busbar, which may be located on the second passivation film layer 80, or be partially embedded in the second passivation film layer 80, or penetrate the second passivation film layer 80. The second welding spots 90 are also configured to be welded to the welding strip.

When the solar cell 100 is a back-contact cell, the first passivation film layer 40 is provided with third fingers (not shown in the figure) and fourth fingers (not shown in the figure). The third fingers penetrate the first passivation film layer 40 so as to make contact with the first doped layer 20. The fourth fingers penetrate the first passivation film layer 40 so as to make contact with the third doped layer 70.

When the solar cell 100 is the back-contact cell, the following two cases may occur:
Case one: as shown in Fig. 12, In some embodiments, on the first surface 11, several first doped layers 20 and several third doped layers 70 may be sequentially and alternately arranged in a first direction, and the first doped layers 20 and the third doped layers 70 all extend in a second direction. The second direction intersects with the first direction. The second direction and the first direction may be a longitudinal direction and a transverse direction of the solar cell 100, respectively. As may be seen from Fig. 12, in the example, the first doped layers 20 and the third doped layers 70 are continuous doped layers in the second direction, and are sequentially and alternately arranged in the first direction.

In the back-contact cell, a busbar may be arranged or not. When the busbar is arranged, the cell includes several third busbars (not shown in the figure) and several fourth busbars (not shown in the figure). The several third busbars and the several fourth busbars are alternately arranged in the second direction, the third fingers are connected to the third busbars and disconnected from the fourth busbars, and the fourth fingers are connected to the fourth busbars and disconnected from the third busbars. The first welding spots 50 are arranged on the third busbars and connected to the third busbars. The second welding spots 90 are arranged on the fourth busbars and connected to the fourth busbars. The several first welding spots 50 may be arranged in an extension direction of the third busbars. The several second welding spots 90 may be arranged in an extension direction of the fourth busbars.

When the busbar is not arranged, the first welding spots 50 and the second welding spots 90 may be directly arranged in a coverage zone of the welding strip of the cell. For instance, the first welding spots 50 may be arranged at disconnection positions of the third fingers, and the second welding spots 90 may be arranged at disconnection positions of the fourth fingers. In this way, the fingers may be directly connected to the welding spots by means of the welding strip without the busbars. It may be understood that, in this case, the welding strip welded to the first welding spots 50 may be electrically connected to all the third fingers, and the welding strip welded to the second welding spots 90 may be electrically connected to all the fourth fingers. Clearly, In some embodiments, the third fingers may be not disconnected from the fourth fingers, and the third fingers and the fourth fingers are isolated from the busbar or the welding strip having opposite polarity through insulation paste, which is not specifically limited herein.

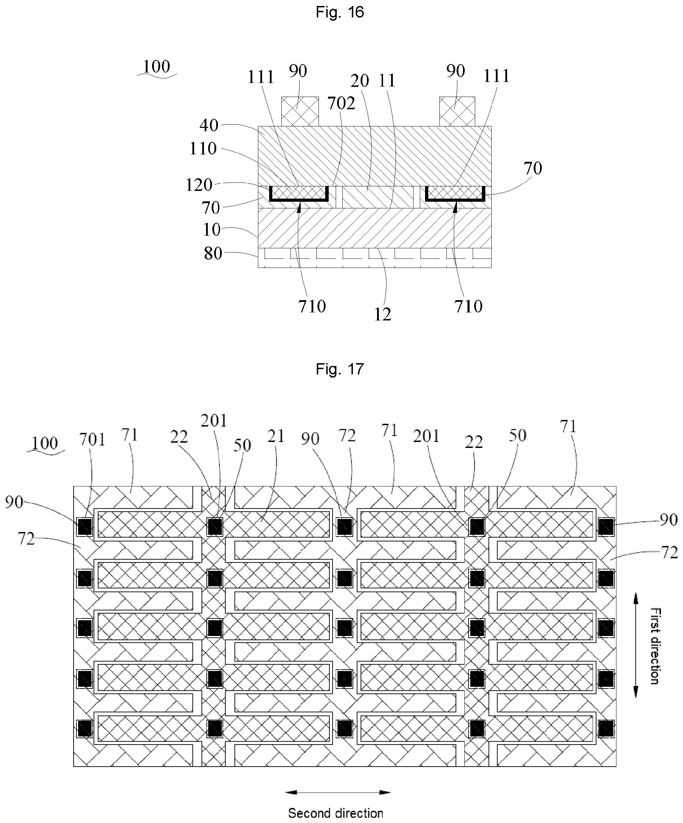

Case two: as shown in Fig. 17, In some embodiments, the first doped layers 20 may include several first doped sub-layers 21 and several second doped sub-layers 22, and the third doped layers 70 may include several third doped sub-layers 71 and several fourth doped sub-layers 72. The several first doped sub-layers 21 and the several third doped sub-layers 71 are sequentially and alternately arranged on the first surface 11 in the first direction, and extend in the second direction. The several second doped sub-layers 22 and the several fourth doped sub-layers 72 are sequentially and alternately arranged on the first surface 11 in the second direction and extend in the first direction, the first doped sub-layers 21 are disconnected from the fourth doped sub-layers 72 and make contact with the second doped sub-layers 22, and the third doped sub-layers 71 are disconnected from the second doped sub-layers 22 and make contact with the fourth doped sub-layers 72. The second doped sub-layers 22 each have the several first preset zones 201. The several first preset zones 201 are arranged in the second direction in a spaced manner. A number of the first welding spots 50 may correspond to a number of the first preset zones 201. In this case, the first welding spots 50 may be arranged above the second doped sub-layers 22, and the second welding spots 90 may be arranged above the fourth doped sub-layers 72.

Specifically, it is understandable that the first doped sub-layers 21 and the second doped sub-layers 22 together constitute the first doped layers 20 in a comb shape, and the third doped sub-layers 71 and the fourth doped sub-layers 72 together constitute the third doped layers 70 in a comb shape. The first doped sub-layers 21 and the second doped sub-layers 22 may be formed through a same process. The third doped layers 71 and the fourth doped sub-layers 72 may be formed through a same process.

Further, in the examples, in the first direction, a length of the first welding spots 50 is greater than that of the second doped layers 30, and a ratio of a length of the first welding spots 50 above the second doped layers 30 to a total length of the first welding spots 50 is greater than or equal to 20%.

In this way, when the length of the first welding spots 50 is large in the first direction, the ratio of the length (that is, a length of overlapping parts between the orthographic projections of the first welding spots 50 in the thickness direction and the second doped layers 30) of the first welding spots 50 above the second doped layers 30 to the total length of the first welding spots 50 is set to be greater than or equal to 20%, such that a welding tensile force of the first welding spots 50 can be effectively ensured, and an insufficient welding tensile force can be avoided.

Preferably, in the examples, in order to ensure the welding tensile force of the first welding spots 50, the ratio of the length of the first welding spots 50 above the second doped layers 30 to the total length of the first welding spots 50 is greater than or equal to 50%.

In some embodiments, a ratio of an area of orthographic projections of the second doped layers 30 on the second doped sub-layers 22 to an area of the second doped sub-layers 22 is smaller than 50%. In this way, the situation that large recombination loss is caused because the second doped layers 30 are likely to be recombined with the second doped sub-layers 22 due to an excessive area ratio of the second doped layers 30 can be avoided.

Specifically, in the examples, the case that "a ratio of an area of orthographic projections of the second doped layers 30 on the second doped sub-layers 22 to an area of the second doped sub-layers 22 is smaller than 50%" may be a case that a ratio of an area of all the second doped layers 30 on a single second doped sub-layer 22 to an area of the single second doped sub-layer 22 is smaller than 50%, or a case that a ratio of the sum of areas of all the second doped layers 30 on the entire back-contact cell to the sum of areas of all the second doped sub-layers 22 is smaller than 50%, which is not specifically limited herein. The former case is preferably selected.

Further, as shown in Fig. 17, in the examples, in the first direction, a distance between two adjacent first welding spots 50 is 3 mm-40 mm.

In this way, the distance between the two adjacent first welding spots 50 is set to be within the rational range, such that the first welding spots 50 may be basically within a rational distance range, and further a same second doped sub-layer 22 may be provided with enough first welding spots 50. Thus, void welding during welding of the welding strip can be avoided, and welding reliability can be ensured.

Specifically, in the examples, the distance between the two adjacent first welding spots 50 may be, for instance, 3 mm, 4 mm, 5 mm, 6 mm, 7 mm, 8 mm, 9 mm, 10 mm, 15 mm, 20 mm, 25 mm, 30 mm, 35 mm, 40 mm, or any numerical value between 3 mm and 40 mm, which is not specifically limited herein.

In the examples, the third doped layers 70 may each have several second preset zones 701. The solar cell 100 may further include fourth doped layers 110. The fourth doped layers 110 are arranged on the second preset zones 701. The several fourth doped layers 110 are arranged in a spaced manner.

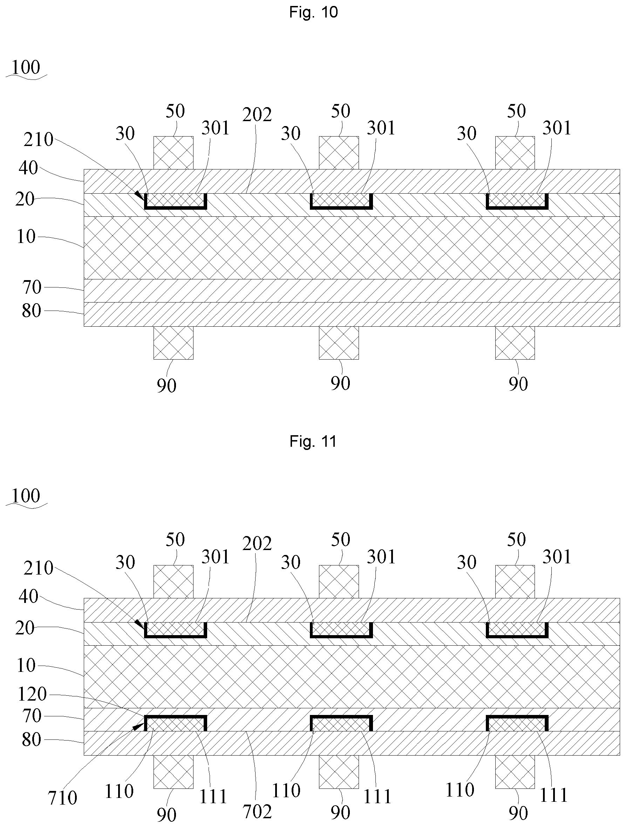

As shown in Figs. 9 and 11, in a case that the third doped layers 70 are arranged on the second surface 12, the second passivation film layer 80 covers the third doped layers 70 and the fourth doped layers 110, and orthographic projections of the second welding spots 90 on the third doped layers 70 at least partially overlap orthographic projections of the fourth doped layers 110 on the third doped layers 70 (that is, the second welding spots 90 at least partially overlap the fourth doped layers 110 in the thickness direction of the solar cell 100).

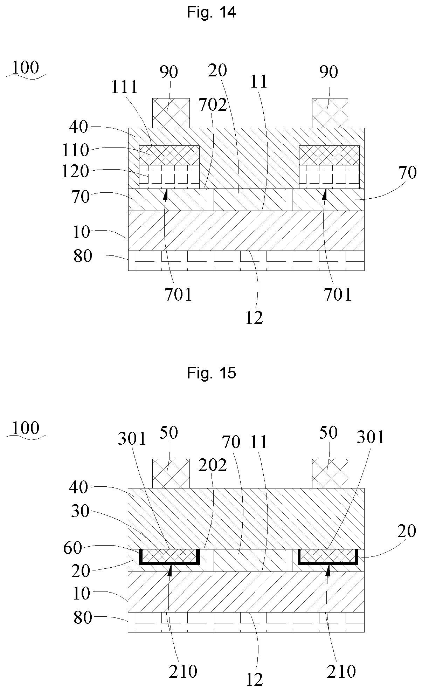

As shown in Figs. 14 and 16, in a case that the third doped layers 70 are arranged on the first surface 11, the first passivation film layer 40 covers the first doped layers 20, the second doped layers 30, the third doped layers 70, and the fourth doped layers 110, and the orthographic projections of the second welding spots 90 on the third doped layers 70 at least partially overlap the orthographic projections of the fourth doped layers 110 on the third doped layers 70 (that is, that is, the second welding spots 90 at least partially overlap the fourth doped layers 110 in the thickness direction of the solar cell 100).

In this way, a tensile force of the second welding spots 90 during welding can be effectively improved while a tensile force pair of the first welding spots 50 during welding can be enhanced, and the second welding spots 90 can be effectively prevented from being detached during welding.

In the examples, polarity of the fourth doped layers 110 is opposite to that of the third doped layers 70.

In a case that the third doped layers 70 are arranged on the second surface 12, roughness of surfaces 111 of the fourth doped layers 110 in contact with the second passivation film layer 80 is greater than that of surfaces 702 of the third doped layers 70 in contact with the second passivation film layer 80.

In a case that the third doped layers 70 are arranged on the first surface 11, roughness of surfaces 111 of the fourth doped layers 110 in contact with the first passivation film layer 40 is greater than that of surfaces 702 of the third doped layers 70 in contact with the first passivation film layer 40.

In this way, with the roughness set, a tensile force of the second welding spots 90 during welding can be further improved.

With reference to Fig. 14, In some embodiments, the second preset zones 701 are part of surfaces of the third doped layers 70 facing away from the silicon substrate 10, and the fourth doped layers 110 are arranged on the second preset zones 701 and all located above the third doped layers 70.

Specifically, as shown in Fig. 14, the second preset zones 701 are partial zones of the surfaces of the third doped layers 70 facing away from the silicon substrate 10, and are basically planar zones. In this case, the fourth doped layers 110 are directly arranged on the third doped layers 70 and are all located on the fourth doped layers 110.

With reference to Fig. 16, in some other examples, the second preset zones 701 may be second embedded recesses 701 formed on the third doped layers 70 in a sunken manner, and the fourth doped layers 110 are stacked in the second embedded recesses 701. The first welding spots 50 at least partially overlap the fourth doped layers 110 in the thickness direction of the solar cell 100.

It may be understood that, in the disclosure, the fourth doped layers 110 may be located in the second embedded recesses 701 as follows: all parts of the first doped layers 30 may be completely accommodated in the second embedded recesses 701, or the first doped layers 30 may partially extend out of the second embedded recesses 701 in the thickness direction, which are not specifically limited herein.

In some embodiments, a depth of the second embedded recesses 701 may be 5 nm-400 nm.

In this way, a poor tension enhancement effect caused when a thickness of the fourth doped layers 110 is too small due to a too small depth of the second embedded recesses 701 can be effectively avoided, or an increase in cost caused when a thickness of the fourth doped layers 110 is too large due to an excessive depth of the second embedded recesses 701 can be avoided.

Specifically, the depth of the second embedded recesses 701 may be 5 nm, 10 nm, 20 nm, 30 nm, 40 nm, 50 nm, 60 nm, 70 nm, 80 nm, 90 nm, 100 nm, 150 nm, 200 nm, 250 nm, 300 nm, 350 nm, 400 nm, or any numerical value between 5 nm and 400 nm, which is not specifically limited herein.

With reference to Figs. 14 and 16, In some embodiments, the solar cell 100 may further include second isolation layers 120. The second isolation layers 120 may be stacked between the third doped layers 70 and the fourth doped layers 110, so as to isolate the third doped layers 70 from the fourth doped layers 110.

In this way, the fourth doped layers 110 are isolated from the third doped layers 70 by means of the second isolation layers 120, such that the fourth doped layers can be prevented from making direct contact with the third doped layers. Meanwhile, a passivation effect of the third doped layers 70 can be ensured.

Specifically, in this case, as shown in Fig. 14, In some embodiments, the second isolation layers 120 may be directly arranged on surfaces of the third doped layers 70 and cover the third doped layers 70, and the fourth doped layers 110 may cover the second isolation layers 120. As shown in Fig. 16, In some embodiments, the second isolation layers 120 may be arranged on inner walls of the second embedded recesses 701. That is, the inner walls of the second embedded recesses 701 are provided with the second isolation layers 120, and the fourth doped layers 110 may cover the second isolation layers 120 in a stacked manner.

Clearly, it may be understood that, In some embodiments, the second isolation layers 120 do not need to be arranged to isolate the third doped layers 70 from the fourth doped layers 110, which is not specifically limited herein.

In some embodiments, a thickness of the second isolation layers 120 may be greater than 2 nm. In this way, higher process difficulty due to a too small thickness of the second isolation layers 120 can be avoided.

In addition, In some embodiments, the second isolation layer 120 may include at least one of a silicon oxide film layer, a silicon nitride film layer, an aluminum oxide film layer, a silicon oxynitride film layer, a silicon carbide film layer, and an intrinsic amorphous silicon film layer.

Specifically, in the examples, the second isolation layers 120 may have a tunneling function or not, and may be an insulation layer or not, which is not specifically limited herein. A specific film layer may be selected according to different types of cells.

For instance, when the cell is a Topcon solar cell or a back-contact cell, the second isolation layer 120 may be at least one of a silicon oxide film layer, a silicon nitride film layer, an aluminum oxide film layer, a silicon oxynitride film layer, and a silicon carbide film layer. The second isolation layer 120 may have a tunneling function or not.

When the cell is an HJT solar cell, the second isolation layer 120 may be an intrinsic amorphous silicon layer. It may be understood that a specific selection of the second isolation layers 120 is only illustrated herein, and cannot be understood as a limitation to the disclosure.

In some embodiments, the orthographic projections of the second welding spots 90 on the third doped layers 70 are completely located in the second preset zones 701. That is, the second welding spots 90 are completely located above the fourth doped layers 110 in the thickness direction of the solar cell 100.

In this way, the second welding spots 90 are completely located in the second preset zones 701, and entire lower portions of the second welding spots 90 are all provided with the fourth doped layers 110, such that a welding tensile force at the second welding spots 90 can be enhanced to the greatest extent, and welding reliability can be ensured.

Specifically, in the examples, an area of the second preset zones 701 may preferably be just equal to the area of the orthographic projections of the second welding spots 90 or slightly greater than the area of the orthographic projections of the second welding spots 90.

Clearly, In some embodiments, the area of the orthographic projections of the second welding spots 90 on the third doped layers 70 may also be greater than that of the orthographic projections of the fourth doped layers 110 on the third doped layers 70 (that is, the area of the second preset zones 701). For instance, a single second welding spot 90 may correspond to a plurality of fourth doped layers 110. In this case, the second welding spot 90 may completely cover the fourth doped layers 110. In this case, a ratio of an overlapping area of the fourth doped layers 110 and the second welding spot 90 to a total area of the second welding spot 90 may be greater than 20%, such that a too small welding tensile force can be avoided.

In some embodiments, a thickness of the fourth doped layers 110 may be 5 nm-400 nm.

In this way, a poor tension enhancement effect due to a too small thickness of the fourth doped layers 110 can be effectively avoided, or higher process difficulty due to a too small thickness of the fourth doped layers 110 can be avoided. Meanwhile, an increase in cost due to an excessive thickness of the fourth doped layers 110 can be avoided.

Specifically, the thickness of the fourth doped layers 110 may be 5 nm, 10 nm, 20 nm, 30 nm, 40 nm, 50 nm, 60 nm, 70 nm, 80 nm, 90 nm, 100 nm, 150 nm, 200 nm, 250 nm, 300 nm, 350 nm, 400 nm, or any numerical value between 5 nm and 400 nm, which is not specifically limited herein.

Further, as shown in Fig. 17, in a case that the third doped layers 70 are arranged on the first surface 11, the first doped layers 20 include several first doped sub-layers 21 and several second doped sub-layers 22, and the third doped layers 70 include several third doped sub-layers 71 and several fourth doped sub-layers 72, the second doped sub-layers 22 each have the several first preset zones 201, the several first preset zones 201 are arranged in the second direction in a spaced manner, and a number of the first welding spots 50 corresponds to a number of the first preset zones 201. The fourth doped sub-layers 72 each have the several second preset zones 701. The several second preset zones 701 are arranged in the first direction in a spaced manner. A number of pairs of the second welding spots 90 corresponds to a number of the second preset zones 701. That is, in this case, the fourth doped layers 110 are arranged on the second preset zones 701 of the fourth doped sub-layers 72.

As shown in Fig. 17, in the examples, in the first direction, a length of the second welding spots 90 may be greater than that of the fourth doped layers 110, and a ratio of a length of the second welding spots 90 above the fourth doped layers 110 to a total length of the second welding spots 90 is greater than or equal to 20%.

In this way, when the length of the second welding spots 90 is large in the first direction, the ratio of the length (that is, a length of overlapping parts between the orthographic projections of the second welding spots 90 in the thickness direction and the fourth doped layers 110) of the second welding spots 90 above the fourth doped layers 110 to the total length of the second welding spots 90 is set to be greater than or equal to 20%, such that a welding tensile force of the second welding spots 90 can be effectively ensured, and an insufficient welding tensile force can be avoided.

Preferably, in the examples, in order to ensure the welding tensile force of the second welding spots 90, the ratio of the length of the second welding spots 90 above the fourth doped layers 110 to the total length of the second welding spots 90 is greater than or equal to 50%.

In some embodiments, a ratio of an area of orthographic projections of the fourth doped layers 110 on the fourth doped sub-layers 72 to an area of the fourth doped sub-layers 72 is smaller than 50%. In this way, the situation that large recombination loss is caused because the fourth doped layers 110 are likely to be recombined with the fourth doped sub-layers 72 due to an excessive area ratio of the fourth doped layers 110 can be avoided.

Specifically, in the examples, the case that "a ratio of an area of orthographic projections of the fourth doped layers 110 on the fourth doped sub-layers 72 to an area of the fourth doped sub-layers 72 is smaller than 50%" may be a case that a ratio of an area of all the fourth doped layers 110 on a single fourth doped sub-layer 72 to an area of the single fourth doped sub-layer 72 is smaller than 50%, or a case that a ratio of the sum of areas of all the fourth doped layers 110 on the entire back-contact cell to the sum of areas of all the fourth doped sub-layers 72 is smaller than 50%, which is not specifically limited herein. The former case is preferably selected.

Further, as shown in Fig. 17, in the examples, in the first direction, a distance between two adjacent second welding spots 90 is 3 mm-40 mm.

In this way, the distance between the two adjacent second welding spots 90 is set to be within the rational range, such that the second welding spots 90 may be basically within a rational distance range, and further a same fourth doped sub-layer 72 may be provided with enough second welding spots 90. Thus, void welding during welding of the welding strip can be avoided, and welding reliability can be ensured.

Specifically, in the examples, the distance between the two adjacent second welding spots 90 may be, for instance, 3 mm, 4 mm, 5 mm, 6 mm, 7 mm, 8 mm, 9 mm, 10 mm, 15 mm, 20 mm, 25 mm, 30 mm, 35 mm, 40 mm, or any numerical value between 3 mm and 40 mm, which is not specifically limited herein.

In the description, the description with reference to terms such as "one example", "some examples", "instance", "specific instance", or "some instances" indicate that specific features, structures, materials, or characteristics described in combination with the examples or instances are included in at least one example or instance of the disclosure. In the description, the schematic description of the above terms do not necessarily refer to a same example or instance. Moreover, the specific features, structures, materials or characteristics described may be combined in a suitable manner in any one or more examples or instances.

Although the examples of the disclosure are illustrated and described, it can be understood that those of ordinary skill in the art can make various changes, modifications, substitutions and variations to the examples without departing from the scope of the appended claims.

## Claims

1. A solar cell (100), comprising:
a silicon substrate (10) having a first surface (11) and a second surface (12) opposite each other;
first doped layers (20) arranged on the first surface (11), wherein the first doped layers (20) each have several first preset zones (201);
several second doped layers (30) arranged on the first preset zones (201), wherein the second doped layers (30) are arranged in a spaced manner and wherein the polarity of the second doped layers (30) is opposite to that of the first doped layers (20);
a first passivation film layer (40) arranged on the second doped layers (30) and the first doped layers (20); and
**characterised in that**
several first welding spots (50) arranged on the first passivation film layer (40), wherein orthographic projections of the first welding spots (50) on the first doped layers (20) at least partially overlap orthographic projections of the second doped layers (30) on the first doped layers (20) and wherein the first welding spots (50) are bonded to upper portions of the first passivation film layer (40), or are partially embedded in the first passivation film layer (40), or at least partially penetrate the first passivation film layer (40) so as to make contact with the second doped layers (30).

2. The solar cell according to claim 1, wherein
roughness of surfaces (301) of the second doped layers (30) in contact with the first passivation film layer (40) is greater than that of surfaces (202) of the first doped layers (20) in contact with the first passivation film layer (40).

3. The solar cell according to claim 1, wherein the first doped layers (20) are P-type doped layers, the second doped layers (30) are N-type doped layers, and the first welding spots (50) are at least partially located above the second doped layers (30).

4. The solar cell according to claim 1, wherein the first preset zones (201) are part of surfaces of the first doped layers (20) facing away from the silicon substrate (10), and the second doped layers (30) are arranged on the first preset zones (201) and all located above the first doped layers (20); and alternatively,
the first preset zones (201) are first embedded recesses formed on the first doped layers (20) in a sunken manner, the second doped layers (30) are arranged in the first embedded recesses, and the first welding spots (50) at least partially overlap the second doped layers (30) in a thickness direction of the solar cell (100).

5. The solar cell according to claim 4, wherein when the first preset zones (201) are the first embedded recesses, a depth of the first embedded recesses is 5 nm-400 nm.

6. The solar cell according to claim 4, further comprising first isolation layers (60), wherein the first isolation layers (60) are stacked between the first doped layers (20) and the second doped layers (30), so as to isolate the first doped layers (20) from the second doped layers (30).

7. The solar cell according to claim 6, wherein a thickness of the first isolation layers (60) is greater than 2 nm.

8. The solar cell according to claim 6, wherein the first isolation layer (60) comprises at least one of a silicon oxide film layer, a silicon nitride film layer, an aluminum oxide film layer, a silicon oxynitride film layer, a silicon carbide film layer, and an intrinsic amorphous silicon film layer.

9. The solar cell according to claim 1, wherein an area of orthographic projections of the first preset zones (201) on the silicon substrate (10) is greater than or equal to that of orthographic projections of the first welding spots (50) on the silicon substrate (10), and the orthographic projections of the first welding spots (50) on the first doped layers (20) are completely located in the first preset zones (201).

10. The solar cell according to claim 1, wherein a thickness of the second doped layers (30) is 5 nm-400 nm.

11. The solar cell according to claim 1, wherein the first passivation film layer (40) comprises at least one of a silicon nitride film layer, an aluminum oxide film layer, a silicon oxynitride film layer, an intrinsic amorphous silicon film layer, and a transparent conductive oxide (TCO) film layer.

12. The solar cell according to any one of claims 1-11, further comprising third doped layers (70), second passivation film layer (80), and several second welding spots (90), wherein polarity of the third doped layers (70) is opposite to that of the first doped layers (20), wherein
the first doped layers (20) are arranged on the first surface (11), the third doped layers (70) are arranged on the second surface (12), the second passivation film layer (80) is arranged on the third doped layers (70), and the second welding spots (90) are arranged on the second passivation film layer (80); and alternatively,
the first doped layers (20) and the third doped layers (70) are arranged on the first surface (11), the first passivation film layer (40) is arranged on the first doped layers (20), the second doped layers (30) and the third doped layers (70), the second welding spots (90) are further arranged on the first passivation film layer (40), and the second passivation film layers (80) is arranged on the second surface (12),
preferably, wherein in a case that the third doped layers (70) are arranged on the first surface (11), on the first surface (11), the several first doped layers (20) and the several third doped layers (70) are sequentially and alternately arranged in a first direction, and the first doped layers and the third doped layers all extend in a second direction, wherein the second direction intersects with the first direction.

13. The solar cell according to claim 12, wherein in a case that the third doped layers (70) are arranged on the first surface (11), the first doped layers (20) comprise several first doped sub-layers (21) and several second doped sub-layers (22), and the third doped layers (70) comprise several third doped sub-layers (71) and several fourth doped sub-layers (72);
the several first doped sub-layers (21) and the several third doped sub-layers (71) are sequentially and alternately arranged on the first surface (11) in a first direction, and extend in a second direction, wherein the second direction intersects with the first direction; and
the several second doped sub-layers (22) and the several fourth doped sub-layers (72) are sequentially and alternately arranged on the first surface (11) in the second direction and extend in the first direction, the first doped sub-layers (21) are disconnected from the fourth doped sub-layers (72) and make contact with the second doped sub-layers (22), and the third doped sub-layers (71) are disconnected from the second doped sub-layers (22) and make contact with the fourth doped sub-layers (72), wherein
the second doped sub-layers (22) each have the several first preset zones (201), and the several first preset zones (201) are arranged in the second direction in a spaced manner,
preferably, wherein in the first direction, a length of the first welding spots (50) is greater than that of the second doped layers (30), and a ratio of a length of the first welding spots (50) above the second doped layers (30) to a total length of the first welding spots (50) is greater than or equal to 20%, or
preferably, wherein in the first direction, a ratio of a length of the first welding spots (50) above the second doped layers (30) to a total length of the first welding spots (50) is greater than or equal to 50%, or
preferably, wherein a ratio of an area of orthographic projections of the second doped layers on the second doped sub-layers to an area of the second doped sub-layers is smaller than or equal to 50% or
preferably, wherein in the first direction, a distance between two adjacent first welding spots (50) is 3 mm-40 mm.

14. The solar cell according to claim 12, wherein the third doped layers (70) each have several second preset zones (701), the solar cell (100) further comprises fourth doped layers (110), the fourth doped layers (110) are arranged on the second preset zones (701), the several fourth doped layers (110) are arranged in a spaced manner, and polarity of the fourth doped layers (110) is opposite to that of the third doped layers (70);
in a case that the third doped layers (70) are arranged on the second surface (12), the second passivation film layer (80) covers the third doped layers (70) and the fourth doped layers (110), and orthographic projections of the second welding spots (90) on the third doped layers (70) at least partially overlap orthographic projections of the fourth doped layers (110) on the third doped layers (70); and
in a case that the third doped layers (70) are arranged on the first surface (11), the first passivation film layer (40) covers the first doped layers (20), the second doped layers (30), the third doped layers (70) and the fourth doped layers (110), and the orthographic projections of the second welding spots (90) on the third doped layers (70) at least partially overlap the orthographic projections of the fourth doped layers (110) on the third doped layers (70).

15. The solar cell according to claim 14, wherein the polarity of the fourth doped layers (110) is opposite to that of the third doped layers (70);
in a case that the third doped layers (70) are arranged on the second surface (12), roughness of surfaces of the fourth doped layers (110) in contact with the second passivation film layer (80) is greater than that of surfaces of the third doped layers (70) in contact with the second passivation film layer (80); and
in a case that the third doped layers (70) are arranged on the first surface (11), roughness of surfaces of the fourth doped layers (110) in contact with the first passivation film layer (40) is greater than that of surfaces of the third doped layers (70) in contact with the first passivation film layer (40).

16. The solar cell according to claim 14, wherein the second preset zones (701) are part of surfaces of the third doped layers (70) facing away from the silicon substrate (10), and the fourth doped layers (110) are arranged on the second preset zones (701) and all located above the third doped layers (70); and alternatively,
the second preset zones (701) are second embedded recesses formed on the third doped layers (70) in a sunken manner, the fourth doped layers (110) are arranged in the second embedded recesses, and the first welding spots (50) at least partially overlap the second doped layers (30) in the thickness direction of the solar cell (100),
preferably wherein when the second preset zones (701) are the second embedded recesses, a depth of the second embedded recesses is 5 nm-400 nm.

17. The solar cell according to claim 14, the solar cell (100) further comprising second isolation layers (120), wherein the second isolation layers (120) are stacked between the third doped layers (70) and the fourth doped layers (110), so as to isolate the third doped layers (70) from the fourth doped layers (110),
preferably wherein a thickness of the second isolation layers (120) is greater than 2 nm, or
preferably wherein the second isolation layer (120) comprises at least one of a silicon oxide film layer, a silicon nitride film layer, an aluminum oxide film layer, a silicon oxynitride film layer, a silicon carbide film layer, and an intrinsic amorphous silicon film layer.

18. The solar cell according to claim 14, wherein in a case that the third doped layers (70) are arranged on the first surface (11), the first doped layers (20) comprise several first doped sub-layers (21) and several second doped sub-layers (22), and the third doped layers (70) comprise several third doped sub-layers (71) and several fourth doped sub-layers (72);
the several first doped sub-layers (21) and the several third doped sub-layers (71) are sequentially and alternately arranged on the first surface (11) in a first direction, and extend in a second direction, wherein the second direction intersects with the first direction; and
the several second doped sub-layers (22) and the several fourth doped sub-layers (72) are sequentially and alternately arranged on the first surface (11) in the second direction and extend in the first direction, the first doped sub-layers (21) are disconnected from the fourth doped sub-layers (72) and make contact with the second doped sub-layers (22), and the third doped sub-layers (71) are disconnected from the second doped sub-layers (22) and make contact with the fourth doped sub-layers (72), wherein
the second doped sub-layers (22) each have the several first preset zones (201), and the several first preset zones (201) are arranged in the first direction in a spaced manner; and the fourth doped sub-layers (72) each have the several second preset zones (701), and the several second preset zones (701) are arranged in the first direction in a spaced manner.

19. A cell component (200), comprising several solar cells (100) according to any one of claims 1-18.

20. A photovoltaic system (1000), comprising the cell component (200) according to claim 19.

## Patentansprüche

1. Solarzelle (100) umfassend:
ein Siliciumsubstrat (10) mit einer ersten Oberfläche (11) und einer zweiten Oberfläche (12), die einander gegenüberliegen;
erste dotierte Schichten (20), die auf der ersten Oberfläche (11) angeordnet sind, wobei die ersten dotierten Schichten (20) jeweils mehrere erste voreingestellte Zonen (201) aufweisen;
mehrere zweite dotierte Schichten (30), die auf den ersten voreingestellten Zonen (201) angeordnet sind, wobei die zweiten dotierten Schichten (30) auf eine beabstandete Weise angeordnet sind und wobei die Polarität der zweiten dotierten Schichten (30) jener der ersten dotierten Schichten (20) entgegengesetzt ist;
eine erste Passivierungsfilmschicht (40), die auf den zweiten dotierten Schichten (30) und den ersten dotierten Schichten (20) angeordnet ist; und
**dadurch gekennzeichnet, dass**
mehrere erste Schweißpunkte (50) auf der ersten Passivierungsfilmschicht (40) angeordnet sind, wobei orthographische Projektionen der ersten Schweißpunkte (50) auf den ersten dotierten Schichten (20) orthographische Projektionen der zweiten dotierten Schichten (30) auf den ersten dotierten Schichten (20) wenigstens teilweise überlappen und wobei die ersten Schweißpunkte (50) an obere Teile der ersten Passivierungsfilmschicht (40) gebunden sind oder teilweise in der ersten Passivierungsfilmschicht (40) eingebettet sind, oder wenigstens teilweise die erste Passivierungsfilmschicht (40) durchdringen, um Kontakt mit den zweiten dotierten Schichten (30) zu bilden.

2. Solarzelle nach Anspruch 1, wobei die Rauheit von Oberflächen (301) der zweiten dotierten Schichten (30) in Kontakt mit der ersten Passivierungsfilmschicht (40) größer als jene von Oberflächen (202) der ersten dotierten Schichten (20) in Kontakt mit der ersten Passivierungsfilmschicht (40) ist.

3. Solarzelle nach Anspruch 1, wobei die ersten dotierten Schichten (20) P-Typ-dotierte Schichten sind, die zweiten dotierten Schichten (30) N-Typ-dotierte Schichten sind und die ersten Schweißpunkte (50) wenigstens teilweise über den zweiten dotierten Schichten (30) angeordnet sind.

4. Solarzelle nach Anspruch 1, wobei die ersten voreingestellten Zonen (201) Teil von Oberflächen der ersten dotierten Schichten (20) sind, die von dem Siliciumsubstrat (10) weg zeigen, und die zweiten dotierten Schichten (30) auf den ersten voreingestellten Zonen (201) angeordnet sind und alle über den ersten dotierten Schichten (20) angeordnet sind; und alternativ
die ersten voreingestellten Zonen (201) erste eingebettete Vertiefungen sind, die auf den ersten dotierten Schichten (20) auf eine abgesenkte Weise gebildet sind, die zweiten dotierten Schichten (30) in den ersten eingebetteten Vertiefungen angeordnet sind und die ersten Schweißpunkte (50) die zweiten dotierten Schichten (30) in einer Dickenrichtung der Solarzelle (100) wenigstens teilweise überlappen.

5. Solarzelle nach Anspruch 4, wobei, wenn die ersten voreingestellten Zonen (201) die ersten eingebetteten Vertiefungen sind, eine Tiefe der ersten eingebetteten Vertiefungen 5 nm bis 400 nm beträgt.

6. Solarzelle nach Anspruch 4, ferner umfassend erste Isolationsschichten (60), wobei die ersten Isolationsschichten (60) zwischen den ersten dotierten Schichten (20) und den zweiten dotierten Schichten (30) gestapelt sind, um die ersten dotierten Schichten (20) von den zweiten dotierten Schichten (30) zu isolieren.

7. Solarzelle nach Anspruch 6, wobei eine Dicke der ersten Isolationsschichten (60) größer als 2 nm ist.

8. Solarzelle nach Anspruch 6, wobei die erste Isolationsschicht (60) wenigstens eine von einer Siliciumoxid-Filmschicht, einer Siliciumnitrid-Filmschicht, einer Aluminiumoxid-Filmschicht, einer Siliciumoxynitrid-Filmschicht, einer Siliciumcarbid-Filmschicht und einer Intrinsisches-Amorphes-Silicium-Filmschicht umfasst.

9. Solarzelle nach Anspruch 1, wobei ein Bereich von orthographischen Projektionen der ersten voreingestellten Zonen (201) auf dem Siliciumsubstrat (10) größer als oder gleich jenem von orthographischen Projektionen der ersten Schweißpunkte (50) auf dem Siliciumsubstrat (10) ist und die orthographischen Projektionen der ersten Schweißpunkte (50) auf den ersten dotierten Schichten (20) vollständig in den ersten voreingestellten Zonen (201) angeordnet sind.

10. Solarzelle nach Anspruch 1, wobei eine Dicke der zweiten dotierten Schichten (30) 5 nm bis 400 nm beträgt.

11. Solarzelle nach Anspruch 1, wobei die erste Passivierungsfilmschicht (40) wenigstens eine von einer Siliciumnitrid-Filmschicht, einer Aluminiumoxid-Filmschicht, einer Siliciumoxynitrid-Filmschicht, einer Intrinsisches-Amorphes-Silicium-Filmschicht und einer Transparentes-Leitfähiges-Oxid(TCO)-Filmschicht umfasst.

12. Solarzelle nach einem der Ansprüche 1-11, ferner umfassend dritte dotierte Schichten (70), eine zweite Passivierungsfilmschicht (80) und mehrere zweite Schweißpunkte (90), wobei die Polarität der dritten dotierten Schichten (70) der der ersten dotierten Schichten (20) entgegengesetzt ist, wobei
die ersten dotierten Schichten (20) auf der ersten Oberfläche (11) angeordnet sind, die dritten dotierten Schichten (70) auf der zweiten Oberfläche (12) angeordnet sind, die zweite Passivierungsfilmschicht (80) auf den dritten dotierten Schichten (70) angeordnet ist und die zweiten Schweißpunkte (90) auf der zweiten Passivierungsfilmschicht (80) angeordnet sind; und alternativ
die ersten dotierten Schichten (20) und die dritten dotierten Schichten (70) auf der ersten Oberfläche (11) angeordnet sind, die erste Passivierungsfilmschicht (40) auf den ersten dotierten Schichten (20), den zweiten dotierten Schichten (30) und den dritten dotierten Schichten (70) angeordnet ist, die zweiten Schweißpunkte (90) ferner auf der ersten Passivierungsfilmschicht (40) angeordnet sind und die zweiten Passivierungsfilmschichten (80) auf der zweiten Oberfläche (12) angeordnet sind,
vorzugsweise wobei in einem Fall, dass die dritten dotierten Schichten (70) auf der ersten Oberfläche (11), auf der ersten Oberfläche (11) angeordnet sind, die mehreren ersten dotierten Schichten (20) und die mehreren dritten dotierten Schichten (70) sequentiell und abwechselnd in einer ersten Richtung angeordnet sind und sich die ersten dotierten Schichten und die dritten dotierten Schichten alle in einer zweiten Richtung erstrecken, wobei sich die zweite Richtung mit der ersten Richtung schneidet.

13. Solarzelle nach Anspruch 12, wobei in einem Fall, dass die dritten dotierten Schichten (70) auf der ersten Oberfläche (11) angeordnet sind, die ersten dotierten Schichten (20) mehrere erste dotierte Teilschichten (21) und mehrere zweite dotierte Teilschichten (22) umfassen und die dritten dotierten Schichten (70) mehrere dritte dotierte Teilschichten (71) und mehrere vierte dotierte Teilschichten (72) umfassen;
die mehreren ersten dotierten Teilschichten (21) und die mehreren dritten dotierten Teilschichten (71) sequentiell und abwechselnd auf der ersten Oberfläche (11) in einer ersten Richtung angeordnet sind und sich in einer zweiten Richtung erstrecken, wobei die zweite Richtung die erste Richtung schneidet; und
die mehreren zweiten dotierten Teilschichten (22) und die mehreren vierten dotierten Teilschichten (72) in der zweiten Richtung sequenziell und abwechselnd auf der ersten Oberfläche (11) angeordnet sind und sich in der ersten Richtung erstrecken, die ersten dotierten Teilschichten (21) von den vierten dotierten Teilschichten (72) getrennt sind und mit den zweiten dotierten Teilschichten (22) Kontakt bilden und die dritten dotierten Teilschichten (71) von den zweiten dotierten Teilschichten (22) getrennt sind und mit den vierten dotierten Teilschichten (72) Kontakt bilden, wobei
die zweiten dotierten Teilschichten (22) jeweils die mehreren ersten voreingestellten Zonen (201) aufweisen und die mehreren ersten voreingestellten Zonen (201) in der zweiten Richtung auf eine beabstandete Weise angeordnet sind,
vorzugsweise wobei in der ersten Richtung eine Länge der ersten Schweißpunkte (50) größer als jene der zweiten dotierten Schichten (30) ist und ein Verhältnis einer Länge der ersten Schweißpunkte (50) über den zweiten dotierten Schichten (30) zu einer Gesamtlänge der ersten Schweißpunkte (50) größer als oder gleich 20 % ist, oder
vorzugsweise wobei in der ersten Richtung ein Verhältnis einer Länge der ersten Schweißpunkte (50) über den zweiten dotierten Schichten (30) zu einer Gesamtlänge der ersten Schweißpunkte (50) größer als oder gleich 50 % ist, oder
vorzugsweise wobei ein Verhältnis einer Fläche von orthographischen Projektionen der zweiten dotierten Schichten auf den zweiten dotierten Teilschichten zu einer Fläche der zweiten dotierten Teilschichten kleiner als oder gleich 50 % ist, oder
vorzugsweise wobei in der ersten Richtung ein Abstand zwischen zwei benachbarten ersten Schweißpunkten (50) 3 mm bis 40 mm beträgt.

14. Solarzelle nach Anspruch 12, wobei die dritten dotierten Schichten (70) jeweils mehrere zweite voreingestellte Zonen (701) aufweisen, die Solarzelle (100) ferner vierte dotierte Schichten (110) umfasst, die vierten dotierten Schichten (110) auf den zweiten voreingestellten Zonen (701) angeordnet sind, die mehreren vierten dotierten Schichten (110) auf eine beabstandete Weise angeordnet sind und die Polarität der vierten dotierten Schichten (110) jener der dritten dotierten Schichten (70) entgegengesetzt ist;
in einem Fall, dass die dritten dotierten Schichten (70) auf der zweiten Oberfläche (12) angeordnet sind, die zweite Passivierungsfilmschicht (80) die dritten dotierten Schichten (70) und die vierten dotierten Schichten (110) bedeckt und orthografische Projektionen der zweiten Schweißpunkte (90) auf den dritten dotierten Schichten (70) orthografische Projektionen der vierten dotierten Schichten (110) auf den dritten dotierten Schichten (70) wenigstens teilweise überlappen; und
in einem Fall, dass die dritten dotierten Schichten (70) auf der ersten Oberfläche (11) angeordnet sind, die erste Passivierungsfilmschicht (40) die ersten dotierten Schichten (20), die zweiten dotierten Schichten (30), die dritten dotierten Schichten (70) und die vierten dotierten Schichten (110) bedeckt und die orthographischen Projektionen der zweiten Schweißpunkte (90) auf den dritten dotierten Schichten (70) wenigstens teilweise die orthographischen Projektionen der vierten dotierten Schichten (110) auf den dritten dotierten Schichten (70) überlappen.

15. Solarzelle nach Anspruch 14, wobei die Polarität der vierten dotierten Schichten (110) jener der dritten dotierten Schichten (70) entgegengesetzt ist;
in einem Fall, dass die dritten dotierten Schichten (70) auf der zweiten Oberfläche (12) angeordnet sind, die Rauheit von Oberflächen der vierten dotierten Schichten (110) in Kontakt mit der zweiten Passivierungsfilmschicht (80) größer als jene von Oberflächen der dritten dotierten Schichten (70) in Kontakt mit der zweiten Passivierungsfilmschicht (80) ist; und
in einem Fall, dass die dritten dotierten Schichten (70) auf der ersten Oberfläche (11) angeordnet sind, ist Rauheit von Oberflächen der vierten dotierten Schichten (110) in Kontakt mit der ersten Passivierungsfilmschicht (40) größer als jene von Oberflächen der dritten dotierten Schichten (70) in Kontakt mit der ersten Passivierungsfilmschicht (40).

16. Solarzelle nach Anspruch 14, wobei die zweiten voreingestellten Zonen (701) Teil von Oberflächen der dritten dotierten Schichten (70) sind, die von dem Siliciumsubstrat (10) weg zeigen, und die vierten dotierten Schichten (110) auf den zweiten voreingestellten Zonen (701) angeordnet sind und alle über den dritten dotierten Schichten (70) angeordnet sind; und alternativ
die zweiten voreingestellten Zonen (701) zweite eingebettete Vertiefungen sind, die auf den dritten dotierten Schichten (70) auf eine abgesenkte Weise gebildet sind, die vierten dotierten Schichten (110) in den zweiten eingebetteten Vertiefungen angeordnet sind und die ersten Schweißpunkte (50) die zweiten dotierten Schichten (30) in der Dickenrichtung der Solarzelle (100) wenigstens teilweise überlappen,
wobei vorzugsweise, wenn die zweiten voreingestellten Zonen (701) die zweiten eingebetteten Vertiefungen sind, eine Tiefe der zweiten eingebetteten Vertiefungen 5 nm bis 400 nm beträgt.

17. Solarzelle nach Anspruch 14, wobei die Solarzelle (100) ferner zweite Isolationsschichten (120) umfasst, wobei die zweiten Isolationsschichten (120) zwischen den dritten dotierten Schichten (70) und den vierten dotierten Schichten (110) gestapelt sind, um die dritten dotierten Schichten (70) von den vierten dotierten Schichten (110) zu isolieren,
wobei vorzugsweise eine Dicke der zweiten Isolationsschichten (120) größer als 2 nm ist, oder
vorzugsweise wobei die zweite Isolationsschicht (120) wenigstens eine von einer Siliciumoxid-Filmschicht, einer Siliciumnitrid-Filmschicht, einer Aluminiumoxid-Filmschicht, einer Siliciumoxynitrid-Filmschicht, einer Siliciumcarbid-Filmschicht und einer Intrinsisches-Amorphes-Silicium-Filmschicht umfasst.

18. Solarzelle nach Anspruch 14, wobei in einem Fall, dass die dritten dotierten Schichten (70) auf der ersten Oberfläche (11) angeordnet sind, die ersten dotierten Schichten (20) mehrere erste dotierte Teilschichten (21) und mehrere zweite dotierte Teilschichten (22) umfassen und die dritten dotierten Schichten (70) mehrere dritte dotierte Teilschichten (71) und mehrere vierte dotierte Teilschichten (72) umfassen;
die mehreren ersten dotierten Teilschichten (21) und die mehreren dritten dotierten Teilschichten (71) sequentiell und abwechselnd auf der ersten Oberfläche (11) in einer ersten Richtung angeordnet sind und sich in einer zweiten Richtung erstrecken, wobei die zweite Richtung die erste Richtung schneidet; und
die mehreren zweiten dotierten Teilschichten (22) und die mehreren vierten dotierten Teilschichten (72) in der zweiten Richtung sequenziell und abwechselnd auf der ersten Oberfläche (11) angeordnet sind und sich in der ersten Richtung erstrecken, die ersten dotierten Teilschichten (21) von den vierten dotierten Teilschichten (72) getrennt sind und mit den zweiten dotierten Teilschichten (22) Kontakt bilden und die dritten dotierten Teilschichten (71) von den zweiten dotierten Teilschichten (22) getrennt sind und mit den vierten dotierten Teilschichten (72) Kontakt bilden, wobei
die zweiten dotierten Teilschichten (22) jeweils die mehreren ersten voreingestellten Zonen (201) aufweisen und die mehreren ersten voreingestellten Zonen (201) in der ersten Richtung auf eine beabstandete Weise angeordnet sind; und die vierten dotierten Teilschichten (72) jeweils die mehreren zweiten voreingestellten Zonen (701) aufweisen und die mehreren zweiten voreingestellten Zonen (701) in der ersten Richtung auf eine beabstandete Weise angeordnet sind.

19. Zellenkomponente (200) umfassend mehrere Solarzellen (100) nach einem der Ansprüche 1-18.

20. Photovoltaiksystem (1000) umfassend die Zellenkomponente (200) nach Anspruch 19.

## Revendications

1. Cellule solaire (100), comprenant :
un substrat de silicium (10) ayant une première surface (11) et une deuxième surface (12) opposées l'une de l'autre ;
des premières couches dopées (20) disposées sur la première surface (11), dans laquelle les premières couches dopées (20) présentent chacune plusieurs premières zones prédéterminées (201) ;
plusieurs deuxièmes couches dopées (30) disposées sur les premières zones prédéterminées (201), dans laquelle les deuxièmes couches dopées (30) sont disposées de manière espacée et dans laquelle la polarité des deuxièmes couches dopées (30) est opposée à celle des premières couches dopées (20) ;
une première couche de film de passivation (40) disposée sur les deuxièmes couches dopées (30) et les premières couches dopées (20) ; et
**caractérisée en ce que**
plusieurs premiers points de soudure (50) disposés sur la première couche de film de passivation (40), dans laquelle les projections orthographiques des premiers points de soudure (50) sur les premières couches dopées (20) chevauchent au moins partiellement des projections orthographiques des deuxièmes couches dopées (30) sur les premières couches dopées (20) et dans laquelle les premiers points de soudure (50) sont liés à des parties supérieures de la première couche de film de passivation (40), ou sont partiellement intégrés dans la première couche de film de passivation (40), ou pénètrent au moins partiellement la première couche de film de passivation (40) de manière à faire contact avec les deuxièmes couches dopées (30).

2. Cellule solaire selon la revendication 1, dans laquelle la rugosité de surfaces (301) des deuxièmes couches dopées (30) en contact avec la première couche de film de passivation (40) est supérieure à celle de surfaces (202) des premières couches dopées (20) en contact avec la première couche de film de passivation (40).

3. Cellule solaire selon la revendication 1, dans laquelle les premières couches dopées (20) sont des couches dopées de type P, les deuxièmes couches dopées (30) sont des couches dopées de type N, et les premiers points de soudure (50) sont au moins partiellement situés au-dessus des deuxièmes couches dopées (30).

4. Cellule solaire selon la revendication 1, dans laquelle les premières zones prédéterminées (201) font partie de surfaces des premières couches dopées (20) tournées à l'opposé du substrat de silicium (10), et les deuxièmes couches dopées (30) sont disposées sur les premières zones prédéterminées (201) et toutes situées au-dessus des premières couches dopées (20) ; et en variante,
les premières zones prédéterminées (201) sont des premiers évidements intégrés formés sur les premières couches dopées (20) de manière enfoncée, les deuxièmes couches dopées (30) sont disposées dans les premiers évidements intégrés, et les premiers points de soudure (50) chevauchent au moins partiellement les deuxièmes couches dopées (30) dans une direction d'épaisseur de la cellule solaire (100).

5. Cellule solaire selon la revendication 4, dans laquelle, lorsque les premières zones prédéterminées (201) sont les premiers évidements intégrés, une profondeur des premiers évidements intégrés est de 5 nm à 400 nm.

6. Cellule solaire selon la revendication 4, comprenant en outre des premières couches d'isolation (60), dans laquelle les premières couches d'isolation (60) sont empilées entre les premières couches dopées (20) et les deuxièmes couches dopées (30), de manière à isoler les premières couches dopées (20) des deuxièmes couches dopées (30).

7. Cellule solaire selon la revendication 6, dans laquelle une épaisseur des premières couches d'isolation (60) est supérieure à 2 nm.

8. Cellule solaire selon la revendication 6, dans laquelle la première couche d'isolation (60) comprend au moins l'une parmi une couche de film d'oxyde de silicium, une couche de film de nitrure de silicium, une couche de film d'oxyde d'aluminium, une couche de film d'oxynitrure de silicium, une couche de film de carbure de silicium et une couche de film de silicium amorphe intrinsèque.

9. Cellule solaire selon la revendication 1, dans laquelle une aire de projections orthographiques des premières zones prédéterminées (201) sur le substrat de silicium (10) est supérieure ou égale à celle de projections orthographiques des premiers points de soudure (50) sur le substrat de silicium (10), et les projections orthographiques des premiers points de soudure (50) sur les premières couches dopées (20) sont complètement situées dans les premières zones prédéterminées (201).

10. Cellule solaire selon la revendication 1, dans laquelle une épaisseur des deuxièmes couches dopées (30) est de 5 nm à 400 nm.

11. Cellule solaire selon la revendication 1, dans laquelle la première couche de film de passivation (40) comprend au moins l'une parmi une couche de film de nitrure de silicium, une couche de film d'oxyde d'aluminium, une couche de film d'oxynitrure de silicium, une couche de film de silicium amorphe intrinsèque et une couche de film d'oxyde conducteur transparent (TCO).

12. Cellule solaire selon l'une quelconque des revendications 1 à 11, comprenant en outre des troisièmes couches dopées (70), une deuxième couche de film de passivation (80) et plusieurs deuxièmes points de soudure (90), dans laquelle la polarité des troisièmes couches dopées (70) est opposée à celle des premières couches dopées (20), dans laquelle
les premières couches dopées (20) sont disposées sur la première surface (11), les troisièmes couches dopées (70) sont disposées sur la deuxième surface (12), la deuxième couche de film de passivation (80) est disposée sur les troisièmes couches dopées (70), et les deuxièmes points de soudure (90) sont disposés sur la deuxième couche de film de passivation (80) ; et en variante,
les premières couches dopées (20) et les troisièmes couches dopées (70) sont disposées sur la première surface (11), la première couche de film de passivation (40) est disposée sur les premières couches dopées (20), les deuxièmes couches dopées (30) et les troisièmes couches dopées (70), les deuxièmes points de soudure (90) sont en outre disposés sur la première couche de film de passivation (40), et les deuxièmes couches de film de passivation (80) sont disposées sur la deuxième surface (12),
de préférence, dans laquelle dans un cas où les troisièmes couches dopées (70) sont disposées sur la première surface (11), sur la première surface (11), les premières couches dopées (20) et les troisièmes couches dopées (70) sont disposées séquentiellement et en alternance dans une première direction, et les premières couches dopées et les troisièmes couches dopées s'étendent toutes dans une deuxième direction, la deuxième direction croisant la première direction.

13. Cellule solaire selon la revendication 12, dans laquelle, dans un cas où les troisièmes couches dopées (70) sont disposées sur la première surface (11), les premières couches dopées (20) comprennent plusieurs premières sous-couches dopées (21) et plusieurs deuxièmes sous-couches dopées (22), et les troisièmes couches dopées (70) comprennent plusieurs troisièmes sous-couches dopées (71) et plusieurs quatrièmes sous-couches dopées (72) ;
la pluralité de premières sous-couches dopées (21) et la pluralité de troisièmes sous-couches dopées (71) sont disposées séquentiellement et en alternance sur la première surface (11) dans une première direction, et s'étendent dans une deuxième direction, la deuxième direction croisant la première direction ; et
les deuxièmes sous-couches dopées (22) et les quatrièmes sous-couches dopées (72) sont disposées séquentiellement et en alternance sur la première surface (11) dans la deuxième direction et s'étendent dans la première direction, les premières sous-couches dopées (21) sont déconnectées des quatrièmes sous-couches dopées (72) et font contact avec les deuxièmes sous-couches dopées (22), les troisièmes sous-couches dopées (71) sont déconnectées des deuxièmes sous-couches dopées (22) et font contact avec les quatrièmes sous-couches dopées (72), dans laquelle
les deuxièmes sous-couches dopées (22) présentent chacune les plusieurs premières zones prédéterminées (201), et les plusieurs premières zones prédéterminées (201) sont disposées dans la deuxième direction d'une façon espacée,
de préférence, dans laquelle dans la première direction, une longueur des premiers points de soudure (50) est supérieure à celle des deuxièmes couches dopées (30), et un rapport entre une longueur des premiers points de soudure (50) au-dessus des deuxièmes couches dopées (30) sur une longueur totale des premiers points de soudure (50) est supérieur ou égal à 20 %, ou
de préférence, dans laquelle, dans la première direction, un rapport entre une longueur des premiers points de soudure (50) au-dessus des deuxièmes couches dopées (30) sur une longueur totale des premiers points de soudure (50) est supérieur ou égal à 50 %, ou
de préférence, dans laquelle un rapport entre une aire de projections orthographiques des deuxièmes couches dopées sur les deuxièmes sous-couches dopées sur une aire des deuxièmes sous-couches dopées est inférieur ou égal à 50 % ou
de préférence, dans la première direction, une distance entre deux premiers points de soudure (50) adjacents est de 3 mm à 40 mm.

14. Cellule solaire selon la revendication 12, dans laquelle les troisièmes couches dopées (70) présentent chacune plusieurs deuxièmes zones prédéterminées (701), la cellule solaire (100) comprend en outre des quatrièmes couches dopées (110), les quatrièmes couches dopées (110) sont disposées sur les deuxièmes zones prédéterminées (701), les quatrièmes couches dopées (110) sont disposées d'une manière espacée, et la polarité des quatrièmes couches dopées (110) est opposée à celle des troisièmes couches dopées (70) ;
dans un cas où les troisièmes couches dopées (70) sont disposées sur la deuxième surface (12), la deuxième couche de film de passivation (80) recouvre les troisièmes couches dopées (70) et les quatrièmes couches dopées (110), et des projections orthographiques des deuxièmes points de soudure (90) sur les troisièmes couches dopées (70) chevauchent au moins partiellement des projections orthographiques des quatrièmes couches dopées (110) sur les troisièmes couches dopées (70) ; et
dans un cas où les troisièmes couches dopées (70) sont disposées sur la première surface (11), la première couche de film de passivation (40) recouvre les premières couches dopées (20), les deuxièmes couches dopées (30), les troisièmes couches dopées (70) et les quatrièmes couches dopées (110), et les projections orthographiques des deuxièmes points de soudure (90) sur les troisièmes couches dopées (70) chevauchent au moins partiellement les projections orthographiques des quatrièmes couches dopées (110) sur les troisièmes couches dopées (70).

15. Cellule solaire selon la revendication 14, dans laquelle la polarité des quatrièmes couches dopées (110) est opposée à celle des troisièmes couches dopées (70) ;
dans un cas où les troisièmes couches dopées (70) sont disposées sur la deuxième surface (12), la rugosité de surfaces des quatrièmes couches dopées (110) en contact avec la deuxième couche de film de passivation (80) est supérieure à celle de surfaces des troisièmes couches dopées (70) en contact avec la deuxième couche de film de passivation (80) ; et
dans un cas où les troisièmes couches dopées (70) sont disposées sur la première surface (11), la rugosité de surfaces des quatrièmes couches dopées (110) en contact avec la première couche de film de passivation (40) est supérieure à celle de surfaces des troisièmes couches dopées (70) en contact avec la première couche de film de passivation (40).

16. Cellule solaire selon la revendication 14, dans laquelle les deuxièmes zones prédéterminées (701) font partie de surfaces des troisièmes couches dopées (70) tournées à l'opposé du substrat de silicium (10), et les quatrièmes couches dopées (110) sont disposées sur les deuxièmes zones prédéterminées (701) et toutes situées au-dessus des troisièmes couches dopées (70) ; et en variante,
les deuxièmes zones prédéterminées (701) sont des deuxièmes évidements intégrés formés sur les troisièmes couches dopées (70) de manière enfoncée, les quatrièmes couches dopées (110) sont disposées dans les deuxièmes évidements intégrés, et les premiers points de soudure (50) chevauchent au moins partiellement les deuxièmes couches dopées (30) dans la direction d'épaisseur de la cellule solaire (100),
de préférence, dans laquelle lorsque les deuxièmes zones prédéterminées (701) sont les deuxièmes évidements intégrés, une profondeur des deuxièmes évidements intégrés est de 5 nm à 400 nm.

17. Cellule solaire selon la revendication 14, la cellule solaire (100) comprenant en outre des deuxièmes couches d'isolation (120), dans laquelle les deuxièmes couches d'isolation (120) sont empilées entre les troisièmes couches dopées (70) et les quatrièmes couches dopées (110), de manière à isoler les troisièmes couches dopées (70) des quatrièmes couches dopées (110),
de préférence dans laquelle une épaisseur des deuxièmes couches d'isolation (120) est supérieure à 2 nm, ou
de préférence, dans laquelle la deuxième couche d'isolation (120) comprend au moins l'une parmi une couche de film d'oxyde de silicium, une couche de film de nitrure de silicium, une couche de film d'oxyde d'aluminium, une couche de film d'oxynitrure de silicium, une couche de film de carbure de silicium et une couche de film de silicium amorphe intrinsèque.

18. Cellule solaire selon la revendication 14, dans laquelle, dans un cas où les troisièmes couches dopées (70) sont disposées sur la première surface (11), les premières couches dopées (20) comprennent plusieurs premières sous-couches dopées (21) et plusieurs deuxièmes sous-couches dopées (22), et les troisièmes couches dopées (70) comprennent plusieurs troisièmes sous-couches dopées (71) et plusieurs quatrièmes sous-couches dopées (72) ;
la pluralité de premières sous-couches dopées (21) et la pluralité de troisièmes sous-couches dopées (71) sont disposées séquentiellement et en alternance sur la première surface (11) dans une première direction, et s'étendent dans une deuxième direction, la deuxième direction croisant la première direction ; et
les deuxièmes sous-couches dopées (22) et les quatrièmes sous-couches dopées (72) sont disposées séquentiellement et en alternance sur la première surface (11) dans la deuxième direction et s'étendent dans la première direction, les premières sous-couches dopées (21) sont déconnectées des quatrièmes sous-couches dopées (72) et font contact avec les deuxièmes sous-couches dopées (22), les troisièmes sous-couches dopées (71) sont déconnectées des deuxièmes sous-couches dopées (22) et font contact avec les quatrièmes sous-couches dopées (72), dans laquelle
les deuxièmes sous-couches dopées (22) présentent chacune les plusieurs premières zones prédéterminées (201), et les plusieurs premières zones prédéterminées (201) sont disposées dans la première direction de manière espacée ; et les quatrièmes sous-couches dopées (72) présentent chacune les deuxièmes zones prédéterminées (701), et les deuxièmes zones prédéterminées (701) sont disposées dans la première direction de manière espacée.

19. Composant cellulaire (200), comprenant plusieurs cellules solaires (100) selon l'une quelconque des revendications 1 à 18.

20. Système photovoltaïque (1000), comprenant le composant cellulaire (200) selon la revendication 19.
